# EUROPEAN PATENT SPECIFICATION

(11) **EP 2 597 686 B1**
(45) Date of publication and mention of the grant of the patent: **31.01.2018**
(21) Application number: 12193953.2
(22) Date of filing: 23.11.2012
(51) Int. Cl.: H01L 33/10, H01L 33/40, H01L 33/46

(54) **Ultraviolet semiconductor light emitting device**
Ultraviolettlichtemittierendes Halbleiterbauelement
Dispositif électroluminescent semi-conducteur à ultra-violet

(30) Priority: 25.11.2011 KR 20110124452
(43) Date of publication of application: 29.05.2013
(73) Proprietor: LG Innotek Co., Ltd., Seoul, 04637 (KR)
(72) Inventor: Kim, Jae Hoon, 100-714 SEOUL (KR)
(74) Representative: Cabinet Plasseraud

(56) References cited:
- EP-A1- 1 885 002
- EP-A1- 1 956 664
- US-A1- 2003 015 715
- US-A1- 2004 099 869
- US-A1- 2006 006 793
- US-A1- 2007 081 571
- US-A1- 2011 049 549

## Description

The present application claims priority of Korean Patent Application No. 10-2011-0124452 filed on November 25, 2011.

### BACKGROUND

The disclosure relates to an ultraviolet semiconductor light emitting device. A light emitting diode (LED) is a semiconductor light emitting device which converts an electric current into light.

Since the semiconductor light emitting device may obtain light having high brightness, semiconductor light emitting device has been widely used for a light source for a display, a light source for a vehicle, and a light source for illumination.

Recently, an ultraviolet semiconductor light emitting device capable of outputting ultraviolet light has been suggested.

However, the ultraviolet light is absorbed inside the ultraviolet semiconductor light emitting device so that quantum efficiency deteriorates.

An example of existing LED devices can be found in US2006/006793A1, which discloses a light-generating device including a device emitting light with a wavelength in the range of 160 nm to 290 nm. One embodiment of D3 is a flip chip-type die configuration for deep UV light-emitting device comprising in this order a substrate, a buffer, an N-doped layer, N-contact metal material, another two N-doped layers, an active layer, a P-doped layer and a P-contact metal.

### SUMMARY

The embodiment provides an ultraviolet semiconductor light emitting device capable of improving quantum efficiency by preventing ultraviolet light from being absorbed.

The embodiment provides an ultraviolet semiconductor light emitting device capable of improving quantum efficiency by reflecting ultraviolet light forward.

According to the embodiment, there is provided an ultraviolet light emitting device including: a first conductive semiconductor layer; an active layer under the first conductive semiconductor layer; a first reflective layer under the active layer; and a second conductive semiconductor layer under the first reflective layer, wherein the first reflective layer comprises a plurality of compound semiconductor layers, wherein the compound semiconductor layer comprises at least two semiconductor materials, and wherein the contents of the at least two semiconductor materials are different from each other.

According to the embodiment, there is provided lighting system including: a substrate; an ultraviolet light emitting device on the substrate; and a molding member surrounding the ultraviolet light emitting device above and comprising a fluorescent material.

The present disclosure contains embodiments from which some embodiments are embodiments of the invention.

### BRIEF DESCRIPTION OF THE DRAWINGS

FIG. 1 is a sectional view illustrating an ultraviolet semiconductor light emitting device according to a first embodiment;
FIG. 2 is a view illustrating a mechanism reflecting ultraviolet light by the ultraviolet semiconductor light emitting device of FIG. 1;
FIG. 3 is a sectional view illustrating a detailed configuration of a second conductive semiconductor layer of FIG. 1;
FIG. 4 is a sectional view illustrating a flip chip ultraviolet semiconductor light emitting device as one application example of the ultraviolet semiconductor light emitting device of FIG. 1;
FIG. 5 is a sectional view illustrating an ultraviolet semiconductor light emitting device according to a second embodiment;
FIG. 6 is a sectional view illustrating an ultraviolet semiconductor light emitting device according to a third embodiment;
FIG. 7 is a sectional view illustrating a detailed configuration of a second conductive semiconductor layer of FIG. 6;
FIG. 8 is a plan view illustrating a shape of the second conductive semiconductor layer of FIG. 6; and
FIG. 9 is a graph illustrating a reflectance according to wavelength of a second conductive layer of the ultraviolet semiconductor light emitting device according to the embodiment.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

Hereinafter, the embodiments will be described with reference to the accompanying drawings. The thickness and size of each layer shown in the drawings may be exaggerated, omitted or schematically drawn for the purpose of convenience or clarity. In addition, the size of elements does not utterly reflect an actual size.

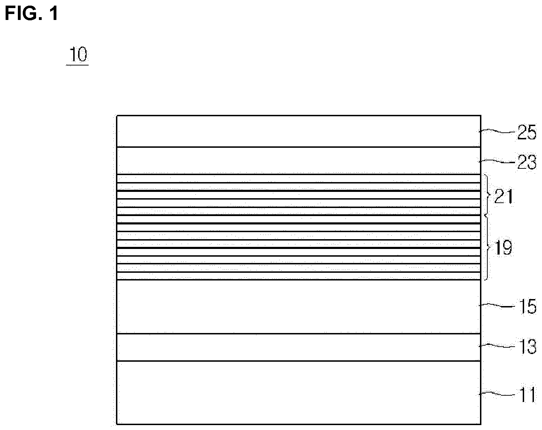

FIG. 1 is a sectional view illustrating an ultraviolet semiconductor light emitting device according to a first embodiment.

Referring to FIG. 1, the an ultraviolet semiconductor light emitting device 10 according to the first embodiment may include a substrate 11, a buffer layer 13, a first conductive semiconductor layer 15, an active layer 19, a second conductive semiconductor layer 21, a third conductive semiconductor layer 23, and a fourth conductive semiconductor layer 25.

The first conductive semiconductor layer 15 may function as both of an electrode layer and a barrier layer, the second conductive semiconductor layer 21 functions as a reflective layer, the third conductive semiconductor layer 23 may function as the barrier layer, and the fourth conductive semiconductor layer 25 may function as an electrode layer, but the embodiment is not limited thereto.

The buffer layer 13 and the first to fourth conductive semiconductor layers 25 may include a group III-V compound semiconductor material or a group II-VI compound semiconductor material. For example, the compound semiconductor material may include Al, In, Ga, and N.

The substrate 11 may include a material having superior thermal conductivity and superior light transmittance, but the embodiment is not limited thereto. For example, the substrate 11 may include at least one of sapphire (Al₂O₃), SiC, Si, GaAs, GaN, ZnO, GaP, InP, and Ge, but the embodiment is not limited thereto.

The buffer layer 13 may attenuate lattice mismatch between the substrate 11 and the first conductive semiconductor layer 15.

For example, the buffer layer 13 may include AlN or GaN, but the embodiment is not limited thereto. The buffer layer 13 may have a multi-layer structure in which AlN and GaN are alternately laminated. For example, the buffer layer 13 may have a multi-layer structure in which AlxGaN(0≤x≤1) layers are alternately laminated with different contents of Al.

The first conductive semiconductor layer 15 may be stably grown on the substrate 11 due to the buffer layer 13.

Although not shown, an undoped semiconductor layer may be formed between the buffer layer 13 and the first conductive semiconductor layer 15. The undoped semiconductor layer has no dopants. Since the undoped semiconductor layer has no dopants, the undoped semiconductor layer may have electric conductivity lower than that of the first conductive semiconductor layer 15. For example, the undoped semiconductor layer may include GaN or AlN, but the embodiment is not limited thereto.

The first conductive semiconductor layer 15 may be formed on the buffer layer 13. For example, the first conductive semiconductor layer 15 may be an n type semiconductor layer including an n type dopant. The first conductive semiconductor layer 15 may include a semiconductor material having a composition equation of InxAlyGal-x-yN (0≤x≤1, 0≤y≤1, 0≤x+y≤1), for example, at least one selected from the group consisting of InAlGaN, GaN, AlGaN, InGaN, AlN, InN, and AlInN, but the embodiment is not limited thereto. The n type dopant may include Si, Ge, or Sn.

The first conductive semiconductor layer 15 may function as an electrode layer for supplying a first carrier, that is, electrons to the active layer 19. The first conductive semiconductor layer 15 may function as a barrier layer for preventing a second carrier, that is, holes supplied from the active layer 19 from being transferred to the buffer layer 13.

The first conductive semiconductor layer 15 functions as a barrier layer and another conductive semiconductor layer functioning as an electrode layer may be formed between the buffer layer 13 and the first conductive semiconductor layer 15.

The active layer 19 may be formed on the first conductive semiconductor layer 15.

For example, electrons and holes supplied from the first semiconductor layer 15 and the fourth conductive semiconductor layers 25 may be recombined with each other in the active layer 19, thereby generating an ultraviolet light.

The active layer 19 may have a stack structure of a well layer and a barrier layer including a compound a group III-V or II-VI semiconductor compound having a band gap for generating the ultraviolet light, but the embodiment is not limited thereto.

For example, the active layer 19 may have a stack structure of InGaN/GaN or InGaN/AlGaN. The barrier layer may have a band gap higher than a band gap of the well layer. That is, the active layer 19 may include one of a single quantum well structure, a multi-quantum well structure (MQW), a quantum dot structure, and a quantum wire structure.

The active layer 19 may include one selected from the group consisting of GaN, InGaN, AlGaN, and AlInGaN or may have a periodicity of GaN, InGaN, AlGaN, and AlInGaN.

The second conductive semiconductor layer 21 may be formed on the active layer 19.

The second conductive semiconductor layer 21 may block the ultraviolet light in the active layer 19 to be supplied to the fourth conductive semiconductor layer 25 and reflect the ultraviolet light. For example, the fourth conductive semiconductor layer 25 may include GaN to function as an electrode layer.

The GaN has a characteristic which absorbs the ultraviolet light. Accordingly, when the ultraviolet light of the active layer 19 is supplied to the fourth conductive semiconductor layer 25, the ultraviolet light is absorbed by the fourth conductive semiconductor layer 25 not to be outputted to the outside so that external quantum efficiency may be remarkably deteriorated.

In the first embodiment, since the second conductive semiconductor layer 21 functioning as a reflective layer is formed between the active layer 19 and the fourth conductive semiconductor layer 25, the ultraviolet light from the active layer 19 is reflected from the second conductive semiconductor layer 21 so that external quantum efficiency may be maximized.

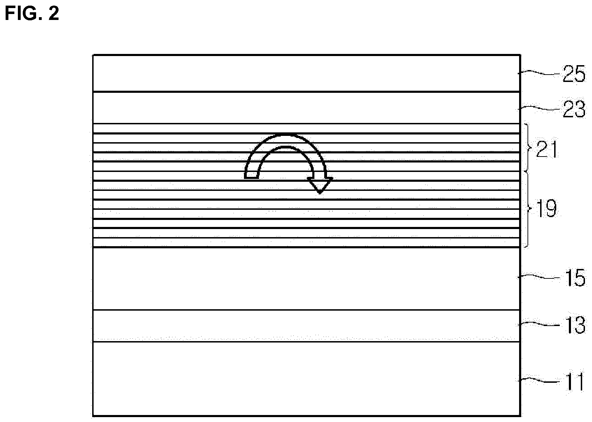

As shown in FIG. 2, the ultraviolet light may be generated from the active layer 19.

The ultraviolet light may be travelled in all directions. Accordingly, the ultraviolet light may be partially travelled to the fourth conductive semiconductor layer 25.

However, the ultraviolet light may be reflected by the second conductive semiconductor layer 21 formed between the active layer 19 and the fourth conductive semiconductor layer 25 such that the ultraviolet light may be travelled to the first conductive semiconductor layer 15 or in a lateral direction.

Accordingly, the ultraviolet light of the active layer 19 is not travelled to the fourth conductive semiconductor layer 25 but reflected to a direction of the first conductive semiconductor layer 15 or in a lateral direction, so that external quantum efficiency may be improved.

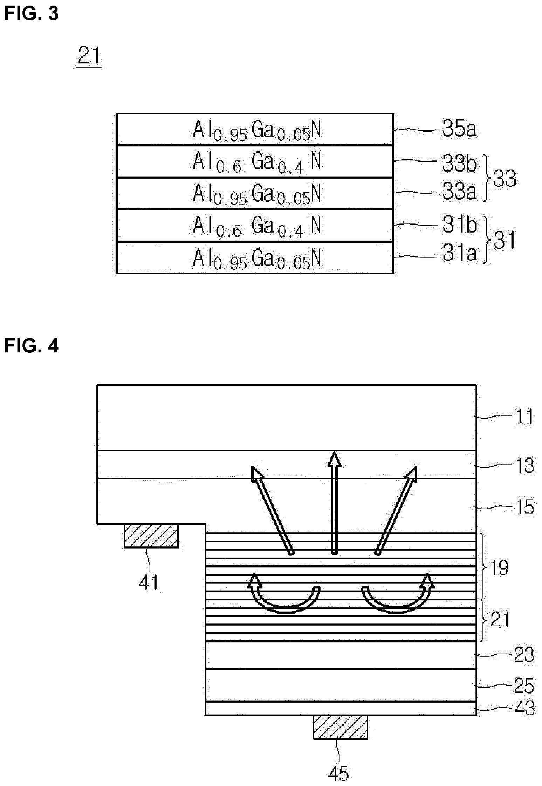

As shown in FIG. 3, the second conductive semiconductor layer 21 includes a plurality of compound semiconductor layers. The second conductive semiconductor layer 21 may have a stack structure of first layers 31a, 33a, and 35a and second layers 31b and 33b.

The number of the first layers 31a, 33a, and 35a and second layers 31b and 33b is odd, but the embodiment is not limited thereto.

The first layers 31a, 33a, and 35a may be defined as odd-numbered layers and the second layers 31b and 33b may be defined as even-numbered layers, respectively, but the embodiment is not limited thereto.

For example, the first layer 31a may be formed as a lowermost layer being in contact with the active layer 19, the second layer 31b may be formed on the first layer 31a, the first layer 33a may be formed on the second layer 31b, the second layer 33b may be formed on the first layer 33a, and the first layer 35a may be formed on the second layer 33b.

For example, the first layer 31a being in contact with the active layer 19 and the second layer 31b on the first layer 31a may be defined as a first pair layer 31. The first and second layers 33a and 33b formed on the first pair layer 31 may be defined as a second pair layer 33.

The second conductive semiconductor layer 21 may include three to five pair layers, but the first embodiment is not limited thereto.

A lowermost layer and an uppermost layer of the second conductive semiconductor layer 21 may have the first layers 31a and 35a in common. That is, a lowermost layer being in contact with the active layer 19 may be configured as the first layer 31a, and an uppermost layer being in contact with the third layer 23 may be configured as the first layer 35a.

The first layers 31a, 33a, and 35a and second layers 31b and 33b may include the same group III-V or II-VI compound semiconductor material. For example, the first layers 31a, 33a, and 35a and second layers 31b and 33b may include AlGaN, but the embodiment is not limited thereto.

However, the first layers 31a, 33a, and 35a and the second layers 31b and 33b may include content of Al different from each other. In addition, the first layers 31a, 33a, and 35a and the second layers 31b and 33b may include content of Ga different from each other.

For example, the content of Al may be higher than the content of Ga in the first layers 31a, 33a, and 35a, and the Al content may be higher than the Ga content in the second layers 31b and 33b, but the embodiment is not limited thereto.

For example, the Al content in the first layers 31a, 33a, and 35a may be higher than that in the second layers 31b and 33b, and the Ga content in the first layers 31a, 33a, and 35a may be lower than that in the second layers 31b and 33b. Through the change of the contents, refractive indexes of the second layers 31b and 33b may be controlled to be higher than those of the first layers 31a, 33a and 35a.

For example, the first layers 31a, 33a, and 35a may include Al content of 95% and Ga content of 5%, whereas the second layers 31b and 33b may include Al content of 60% and Ga content of 40%, but the embodiment is not limited thereto. In this case, the refractive index of the first layers 31a, 33a, and 35a may be 2.1 and the refractive index of the second layers 31b and 33b may be 2.45.

A lowermost layer of the second conductive semiconductor layer 21 and an uppermost layer of the active layer 19 may serve as a barrier layer. In this case, the first layer 31a may be commonly used as the uppermost layer of the active layer 19 and the lowermost layer of the second conductive semiconductor layer 21, and the second layer 31b of the second conductive semiconductor layer 21 may be formed on the first layer 31a.

Meanwhile, the active layer 19 being in contact with the first layers 31a, 33a, and 35a serving as the lowermost layer 21 of the second conductive semiconductor layer 21 has a refractive index higher than a refractive index of the first layer 31a serving as the lowermost layer. The third conductive semiconductor layer 23 being in contact with the first layer 35a serving as the uppermost layer of the second conductive semiconductor layer 21 may has a refractive index higher than a refractive index of the first layer 31a serving as the uppermost layer.

As described above, the second conductive semiconductor layer 21 may function as a reflective layer by laminating the first layers 31a, 33a, and 35a having a low refractive index and the second layers 31b and 33b having a high refractive index.

In the second conductive semiconductor layer 21, each of the first layers 31a, 33a, and 35a may have a thickness larger than that of each of the second layers 31b and 33b, but the embodiment is not limited thereto. The first layers 31a, 33a, and 35a may have a thickness in the range of 30nm to 40nm, and the second layers 31b and 33b may have a thickness in the range of 20nm to 30nm, but the embodiment is not limited thereto.

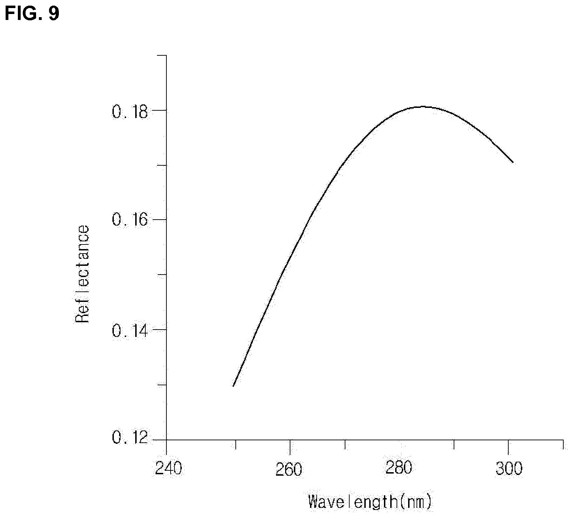

As shown in FIG. 9, a reflectance of the second conductive semiconductor layer 21 may be changed according to wavelength.

The second conductive semiconductor layer 21 of the first embodiment may a maximum reflectance in wavelength in the range of 270nm to 290nm. Accordingly, the active layer 19 of the first embodiment may generate an ultraviolet light having wavelength in the range of 270 nm to 290 nm.

The second conductive semiconductor layer 21 of the first embodiment may mainly reflect the ultraviolet light of wavelength in the range of 270nm to 290nm, but the embodiment is not limited thereto.

That is, the second conductive semiconductor layer 21 may be designed to have a maximum reflectance for the ultraviolet light of wavelength in the range of 270nm to 290nm by changing the contents and thicknesses of the first layers 31a, 33a, and 35a and the second layers 31b and 33b.

Meanwhile, the first layers 31a, 33a, and 35a and the second layers 31b and 33b of the first conductive semiconductor layer 21 may include an n type dopant or a p type dopant.

The first layers 31a, 33a, and 35a and the second layers 31b and 33b of the first conductive semiconductor layer 21 may include no dopants.

One of the first layers 31a, 33a, and 35a and the second layers 31b and 33b of the first conductive semiconductor layer 21 includes an n type dopant or a p type dopant, and the other may not include both of the n type dopant and the p type dopant. For example, the first layers 31a, 33a, and 35a may include the n type dopant and the second layers 31b and 33b may include the p type dopant, but the embodiment is not limited thereto.

A third conductive semiconductor layer 23 functioning as a barrier layer may be formed on the second conductive semiconductor layer 21.

The third conductive semiconductor layer 23 may include a semiconductor material having a composition equation of InxAlyGal-x-yN (0≤x≤1, 0≤y≤1, 0≤x+y≤1), for example, at least one selected from the group consisting of InAlGaN, GaN, AlGaN, InGaN, AlN, InN, and AlInN, but the embodiment is not limited thereto.

For example, the third conductive semiconductor layer 23 may include AlGaN, but the embodiment is not limited thereto. For example, the third conductive semiconductor layer 23 may be a p type semiconductor layer having a p type dopant. The p type dopant may include Mg, Zn, Ca, Sr, or Ba.

A fourth conductive semiconductor layer 25 functioning as an electrode layer may be formed on the third conductive semiconductor layer 23.

The fourth conductive semiconductor layer 25 may include a semiconductor material having a composition equation of InxAlyGal-x-yN (0≤x≤1, 0≤y≤1, 0≤x+y≤1), for example, at least one selected from the group consisting of InAlGaN, GaN, AlGaN, InGaN, AlN, InN, and AlInN, but the embodiment is not limited thereto.

For example, the fourth conductive semiconductor layer 25 may include may be a p type semiconductor layer having a p type dopant. For example, the fourth conductive semiconductor layer 25 may include AlGaN, but the embodiment is not limited thereto. The p type dopant may include Mg, Zn, Ca, Sr, or Ba.

Accordingly, the first conductive semiconductor layer 15 and the fourth conductive semiconductor layer 25 may function as an electrode layer.

For example, the first conductive semiconductor layer 15 may function as an n type electrode layer and the fourth conductive semiconductor layer 25 may function as a p type electrode layer. Accordingly, electrons from the first conductive semiconductor layer 15 may be provide to the active layer 19, and holes from the fourth conductive semiconductor layer 25 may be provided to the active layer 19. The electrons and holes supplied from the first semiconductor layer 15 and the fourth conductive semiconductor layers 25 are recombined with each other in the active layer 19, thereby generating an ultraviolet light having wavelength corresponding to a band gap determined by a material of the active layer 19, for example, wavelength in the range of 270 nm to 290 nm.

Meanwhile, when the fourth conductive semiconductor layer 25 performs both functions of the electrode layer and the barrier layer, the third conductive semiconductor layer 23 may not be formed.

When the third conductive semiconductor layer 23 is not formed, the fourth conductive semiconductor layer 25 may make contact with a top surface of the second conductive semiconductor layer 21.

In the first embodiment, to prevent the ultraviolet light from the active layer 19 from being absorbed by the fourth conductive semiconductor layer 25, the second conductive semiconductor layer 21 capable of reflecting the ultraviolet light may be formed between the active layer 19 and the fourth conductive semiconductor layer 25.

FIG. 4 is a sectional view illustrating a flip chip ultraviolet semiconductor light emitting device as one application example of the ultraviolet semiconductor light emitting device of FIG. 1.

As shown in FIG. 4, for example, the ultraviolet semiconductor light emitting device 100 of the first embodiment may be applied as a flip type ultraviolet semiconductor light emitting device, but the embodiment is not limited thereto.

The flip type ultraviolet semiconductor light emitting device may have a turnover structure of the type ultraviolet semiconductor light emitting device 10.

That is, the buffer layer 13 may be formed below the substrate 11, the first conductive semiconductor layer 15 may be formed below the buffer layer 13, and the active layer 19 may be formed below the first conductive semiconductor layer 15. The second conductive semiconductor layer 21 may be formed below the active layer 19, third conductive semiconductor layer 23 may be formed below the second conductive semiconductor layer 21, and the fourth conductive semiconductor layer 25 may be formed below the third conductive semiconductor layer 23.

Since the flip type ultraviolet semiconductor light emitting device emits the ultraviolet light laterally or upward, a reflective layer 43 may be formed below the fourth conductive semiconductor layer 25 to prevent the ultraviolet light emitted from the active layer 19 from being travelled downward,.

The reflective layer 43 may include a metallic material. For example, the metallic material may include one selected from the group consisting of Ag, Ni, Al, Rh, Pd, Ir, Ru, Mg, Zn, Pt, Au, and Hf, and an alloy thereof.

Before or after forming the reflective layer 43, the fourth conductive semiconductor layer 25, the third conductive semiconductor layer 23, the second conductive semiconductor layer 21, and the active layer 19 may be are mesa-etched so that the first conductive semiconductor layer 15 is partially exposed. A surface of the first conductive semiconductor layer 15 may be partially etched through a mesa etching process.

A first electrode 41 may be provided below the first conductive semiconductor 15 exposed through the mesa etching, and a second electrode 45 may be provided below the reflective layer 43 or the fourth conductive semiconductor layer 25.

A top surface of the second conductive semiconductor layer 19 may be disposed at a location lower than a top surface of the first electrode 41, but the embodiment is not limited thereto.

The second conductive semiconductor layer 19 may horizontally overlap with at least a part of the first electrode 41, but the embodiment is not limited thereto.

Meanwhile, as described above, the second conductive semiconductor layer 21 may function as a reflective layer capable of reflecting the ultraviolet light. If the second conductive semiconductor layer 21 may reflect the ultraviolet light of the active layer 19 upward, the reflective layer 43 may not be formed below the fourth conductive semiconductor layer 25. In this case, a transparent conductive layer instead of the reflective layer 43 may be formed below the fourth conductive semiconductor layer 25, and the second electrode 45 may be provided below the transparent conductive layer, but the embodiment is not limited thereto. Since the transparent conductive layer may serve as a current spreading layer, the transparent conductive layer has the size at least corresponding to the size of the active layer, but the embodiment is not limited thereto. For example, the transparent conductive layer may include at least one selected from the group consisting of ITO, IZO(In-ZnO), GZO(Ga-ZnO), AZO(Al-ZnO), AGZO(Al-Ga ZnO), IGZO(In-Ga ZnO), IrOx, RuOx, RuOx/ITO, Ni/IrOx/Au, and Ni/IrOx/Au/ITO, but the embodiment is not limited thereto.

Light generated from the active layer 19 and travelled downward is reflected from the second conductive semiconductor layer 21 and the reflected light is travelled upward or laterally so that external quantum efficiency may be improved.

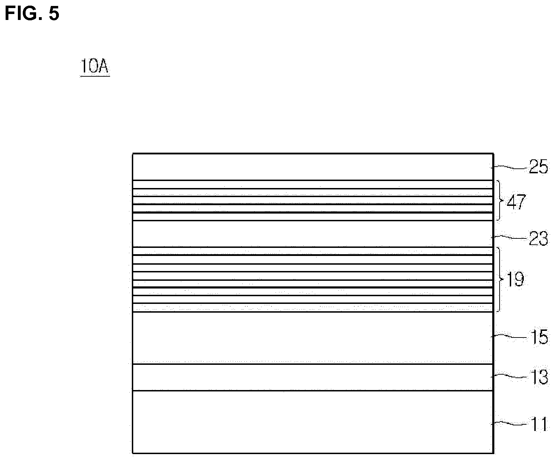

FIG. 5 is a sectional view illustrating an ultraviolet semiconductor light emitting device according to a second embodiment.

The second embodiment is substantially the same as the first embodiment except that a second conductive semiconductor layer 47 is formed between a third conductive semiconductor layer 23 and a fourth conductive semiconductor layer 25.

Like or the same elements in the second embodiment are designated by like or the same numerals are used in the first embodiment, and a detailed description thereof is omitted.

Referring to FIG. 5, the ultraviolet semiconductor light emitting device 10A according to the second embodiment may include a substrate 11, a buffer layer 13, a first conductive semiconductor layer 15, an active layer 19, a second conductive semiconductor layer 47, a third conductive semiconductor layer 23, and a fourth conductive semiconductor layer 25.

The second conductive semiconductor layer 47 may be or not formed on the active layer 19, but the embodiment is not limited thereto.

The second conductive semiconductor layer 47 may be formed on the third conductive semiconductor layer 23 and the fourth conductive semiconductor layer 25 may be formed on the second conductive semiconductor layer 47.

That is, the second conductive semiconductor layer 47 may be formed between the third conductive semiconductor layer 23 and the fourth conductive semiconductor 25.

The ultraviolet light generated from the active layer 19 may be travelled in all directions. A part of the ultraviolet light may be travelled to the second conductive semiconductor layer 47 via the third conductive semiconductor layer 23.

The ultraviolet light travelled to the second conductive semiconductor layer 47 is blocked by the second conductive semiconductor layer 47 so that the ultraviolet light is not travelled to the fourth conductive semiconductor layer 25 including GaN capable of absorbing the ultraviolet light. Thus, deterioration of the external quantum efficiency caused by the absorption of the ultraviolet light by the fourth conductive semiconductor layer 25 may be prevented.

The second conductive semiconductor layer 47 may reflect the ultraviolet light passing through the third conductive semiconductor layer 23 such that the ultraviolet light can be travelled again to the active layer 19 or the first conductive semiconductor layer 15.

Accordingly, the ultraviolet light passing through the third conductive semiconductor layer 23 is blocked by the second conductive semiconductor layer 47 and is reflected from the second conductive semiconductor 47 so that the external quantum efficiency may be improved.

Meanwhile, as a combination of the first and second embodiments, the second conductive semiconductor layer 47 may be formed between the active 19 and the third conductive semiconductor layer 23 and between the third conductive semiconductor layer 23 and the fourth conductive semiconductor layer 25. As described above, since the second conductive semiconductor layer 47 having a reflective function is formed at at least two regions, the light generated from the active layer 19 is prevented from being travelled to the fourth conductive semiconductor layer 25 to minimize optical loss so that the external quantum efficiency may be maximized.

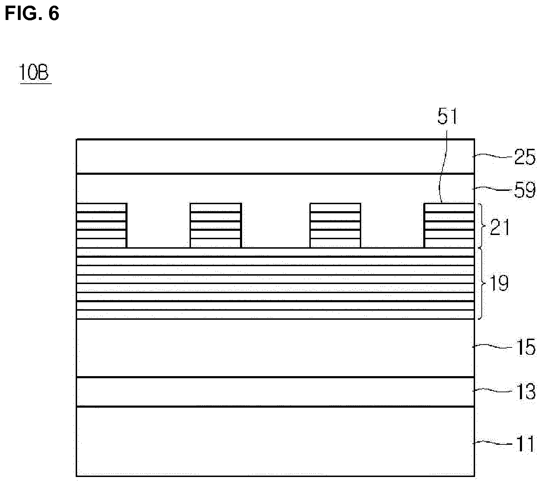

FIG. 6 is a sectional view illustrating an ultraviolet semiconductor light emitting device according to a third embodiment.

Referring to FIG. 6, in the ultraviolet semiconductor light emitting device 10B according to the third embodiment, which is the embodiment of the claimed invention, the second conductive semiconductor layer 21 on the active layer 19 includes a plurality of patterns 51. Each of the patterns 51 may include a plurality of pair layers 53 and 55 in which the first layers 53a, 55a, and 57a and the second layers 53b and 55b are paired.

The first layers 53a, 55a, and 57a and the second layers 53b and 55b may be understood from the first embodiment, and thus a detailed description thereof is omitted.

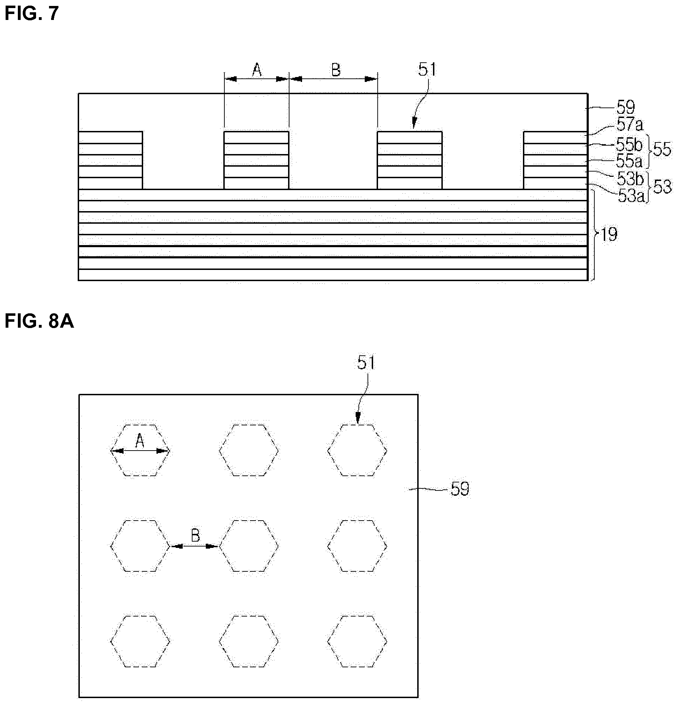

The patterns 51 may have a polygonal shape including a triangular shape, a square shape, a pentagonal shape, and a hexagonal shape (FIG. 8A), but the embodiment is not limited thereto.

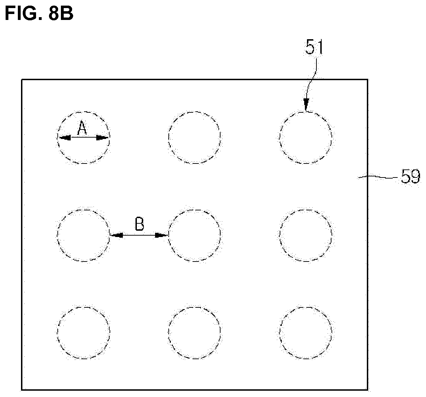

The patterns 51 may has a circular shape (FIG. 8B) or a cylindrical shape, but the embodiment is not limited thereto.

The patterns 51 may be uniformly or randomly disposed.

A side of the pattern 51 may be inclined with respect to a horizontal line, for example, a top surface of the active layer 19, but the embodiment is not limited thereto.

In this case, a width of the pattern 51 may become gradually reduced upward. That is, among the first layers 53a, 55a, and 57a and the second layers 53b and 55b, widths of layers located at an upper position may be smaller than widths of layers located at a lower position.

To the contrary, a width of the pattern 51 may become gradually increased upward. That is, among the first layers 53a, 55a, and 57a and the second layers 53b and 55b, the widths of layers located at the upper position may be larger than the widths of layers located at the lower position.

The side of the pattern 51 may be perpendicular to the top surface of the active layer 19, but the embodiment is not limited thereto. In the case, the widths of the layers 53a, 53b, 55a, 55b, 57a may be the same as each other.

FIG. 7 is a sectional view illustrating a detailed configuration of a second conductive semiconductor layer of FIG. 6.

As shown in FIG. 7, an interval B between the patterns 51 may be smaller than a width A of the pattern 51, but the embodiment is not limited thereto.

The width A of the pattern 51 may be in the range of 0.5 *µ*m to 1 *µ*m, and the interval B of the patterns 51 may be in the range of 1 *µ*m to 2 *µ*m.

The third conductive semiconductor layer 59 is formed on the top surface of the active layer 19 between the patterns 51 of the second conductive semiconductor layer 21 and top surfaces of the patterns.

The third conductive semiconductor layer 59 makes contact with the top surface of the active layer 19 between the patterns 51 and be formed on sides and top surfaces of the pattern 51.

During a growth process, the third conductive semiconductor layer 59 may be grown from the top surface of the active layer 19 between the patterns 51. The third conductive semiconductor layer 59 may be grown from the top surfaces of the patterns 51 as well as in a space between the patterns 51.

The third conductive semiconductor layer 59 and the active layer 19, for example, barrier layers in a multi-quantum well structure may include the same group III-V or group II-VI compound semiconductor material. For example, a barrier layer of the active layer 19 and the third conductive semiconductor layer 59 may include AlGaN in common, but the embodiment is not limited thereto.

Since barrier layers of the third conductive semiconductor layer 59 and the active layer 19 may include the same group III-V or group II-VI compound semiconductor material, the third conductive semiconductor layer 59 may be stably grown without crack from the active layer 19 between the patterns 51 of the second conductive semiconductor layer 21.

In the third embodiment, since holes of the fourth conductive semiconductor layer 25 may be provided to the active layer 19 through the third conductive semiconductor layer 59 between the patterns 51 of the second conductive semiconductor layer 21 without passing through the patterns 51 of the second conductive semiconductor layer 21, light efficiency may be improved caused by improvement in current injection efficiency.

According to the third embodiment, the second conductive semiconductor layer 21 includes a plurality of patterns 51 to further improve reflective efficiency of the ultraviolet light.

When the fourth conductive layer 25 functions as both of an electrode layer and a barrier layer, the third conductive semiconductor layer 59 may not be formed.

When the third conductive semiconductor layer 59 is not formed, the fourth conductive semiconductor layer 25 may make contact with top surfaces of the patterns 51 of the second conductive semiconductor layer 21 and a top surface of the active layer 19 between the patterns 51 of the second conductive semiconductor layer 21.

The third embodiment, which is the embodiment of the claimed invention is associated with the first embodiment. That is, the third embodiment is prepared by forming the second conductive semiconductor layer 21 of the first embodiment including a plurality of patterns 51.

Although not shown, a second conductive semiconductor layer having a plurality of patterns is applicable to the second embodiment. That is, the second conductive semiconductor layer 47 of the second embodiment has a plurality of patterns, and the fourth conductive semiconductor layer 25 may make contact with a top surface of the third conductive semiconductor layer 23 between the patterns and top surfaces of the patterns, but the embodiment is not limited thereto.

According to the embodiment, the second conductive semiconductor layer functioning as a reflective layer is formed between the active layer and the fourth conductive semiconductor layer, so that the ultraviolet light of the active layer is reflected from the second conductive semiconductor layer, thereby maximizing the external quantum efficiency.

According to the embodiment, since holes of the fourth conductive semiconductor layer may be provided to the active layer via the third conductive semiconductor layer between the patterns of the second conductive semiconductor layer without passing through the patterns of the second conductive semiconductor layer according to the second conductive semiconductor layer, current spreading effect may be improved.

According to the embodiment, the second conductive semiconductor layer has a plurality of patterns so that the reflective efficiency of the ultraviolet light may be further improved due to the patterns.

Meanwhile, the ultraviolet semiconductor light emitting devices 10, 10A, and 10B according to the embodiments may be fabricated as a package using a molding member including a fluorescent material or a lighting system with the package.

To use the light emitting devices 10, 10A, and 10B as the lighting system, the ultraviolet light thereof must be converted to visible light.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the scope of the invention defined by the appended claims. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

## Claims

1. An ultraviolet light emitting device (10) comprising:
a first conductive semiconductor layer (15) including an n type dopant;
an active layer (19) under the first conductive semiconductor layer (15);
a second conductive semiconductor layer (21) to form a first reflective layer under the active layer (19); and
a third conductive semiconductor layer (59) including a p type dopant under the second conductive semiconductor layer (21),
wherein the second conductive semiconductor layer (21) comprises a plurality of compound semiconductor layers (31a, 31b, 33a, 33b, 35a) comprising at least two semiconductor materials, wherein the contents of the at least two semiconductor materials are different from each other,
wherein the first reflective layer (21) comprises a plurality of patterns (51) spaced apart from each other, and
wherein the third conductive semiconductor layer (59) is directly in contact with the active layer (19) between the patterns (51).

2. The ultraviolet light emitting device (10) according to claim 1, further comprising:
a fourth conductive semiconductor layer (25) under the third conductive semiconductor layer (59).

3. The ultraviolet light emitting device (10) according to claim 2, further comprising:
a second reflective layer (47) between the fourth conductive semiconductor layer (25) and the third conductive semiconductor layer (59).

4. The ultraviolet light emitting device (10) according to claim 1, wherein a lowermost layer and an uppermost layer of the first reflective layer (21) comprises at least two semiconductor layers (31a, 35a) having the same contents.

5. The ultraviolet light emitting device (10) according to claim 1, wherein an uppermost layer (31a) of the first reflective layer (21) is a lowermost layer of the active layer (19).

6. The ultraviolet light emitting device (10) according to claim 1, wherein an uppermost layer (31a) of the first reflective layer (21) is a barrier layer of the active layer (19).

7. The ultraviolet light emitting device (10) according to claim 1, wherein the active layer (19) has a refractive index greater than that of an uppermost layer of the first reflective layer (21).

8. The ultraviolet light emitting device according to claim 1, wherein the third conductive semiconductor layer (59) has a refractive index greater than that of a lowermost layer (31a) of the first reflective layer (21).

9. The ultraviolet light emitting device (10) according to claim 1, wherein the first reflective layer (21) includes a material for reflecting a ultraviolet light having a wavelength of 270nm to 290nm.

10. The ultraviolet light emitting device (10) according to claim 1, wherein the first reflective layer (21) includes a dopant the same as that of the first conductive semiconductor layer (15).

11. The ultraviolet light emitting device (10) according to claim 1, wherein the first reflective layer (21) includes a dopant the same as that of the third conductive semiconductor layer (59).

12. The ultraviolet light emitting device (10) according to claim 1, wherein the first reflective layer (21) includes a semiconductor material the same as that of the third conductive semiconductor layer (59).

13. The ultraviolet light emitting device (10) according to claim 2, wherein the first reflective layer (21) includes a semiconductor material different from that of the third conductor semiconductor layer (59).

14. The ultraviolet light emitting device (10) according to claim 2, wherein one layer of the first reflective layer (21), the fourth conductive semiconductor layer (25) and the third conductive semiconductor layer (59) has a semiconductor material different from that of the remaining layers of the first reflective layer, the fourth conductive semiconductor layer and the third conductive semiconductor layer.

15. The ultraviolet light emitting device (10) according to claim 2, further comprising:
a first electrode (41) under the first conductive semiconductor layer (15); and
a second electrode (45) under one layer of the third conductive semiconductor layer (59) and the fourth conductive semiconductor layer (25),
wherein the first reflective layer (21) overlaps with at least a portion of the first electrode (41) in a horizontal direction.

## Patentansprüche

1. Ultraviolettlicht emittierende Vorrichtung (10), umfassend:
eine erste leitfähige Halbleiterschicht (15), umfassend einen Dotanten vom n-Typ;
eine aktive Schicht (19) unter der ersten leitfähigen Halbleiterschicht (15);
eine zweite leitfähige Halbleiterschicht (21), um eine erste reflektierende Schicht unter der aktiven Schicht (19) zu bilden; und
eine dritte leitfähige Halbleiterschicht (59), umfassend einen Dotanten vom p-Typ, unter der zweiten leitfähigen Halbleiterschicht (21),
wobei die zweite leitfähige Halbleiterschicht (21) eine Mehrzahl von mindestens zwei Halbleitermaterialien umfassenden Verbundhalbleiterschichten (31a, 31b, 33a, 33b, 35a) umfasst, wobei sich die Gehalte der mindestens zwei Halbleitermaterialien voneinander unterscheiden,
wobei die erste reflektierende Schicht (21) eine Mehrzahl von voneinander beabstandeten Strukturen (51) umfasst, und
wobei die dritte leitfähige Halbleiterschicht (59) in direktem Kontakt mit der aktiven Schicht (19) zwischen den Strukturen (51) ist.

2. Ultraviolettlicht emittierende Vorrichtung (10) nach Anspruch 1, weiterhin umfassend:
eine vierte leitfähige Halbleiterschicht (25) unter der dritten leitfähigen Halbleiterschicht (59).

3. Ultraviolettlicht emittierende Vorrichtung (10) nach Anspruch 2, weiterhin umfassend:
eine zweite reflektierende Schicht (47) zwischen der vierten leitfähigen Halbleiterschicht (25) und der dritten leitfähigen Halbleiterschicht (59).

4. Ultraviolettlicht emittierende Vorrichtung (10) nach Anspruch 1, wobei eine unterste Schicht und eine oberste Schicht der ersten reflektierenden Schicht (21) mindestens zwei Halbleiterschichten (31a, 35a) mit den gleichen Gehalten umfassen.

5. Ultraviolettlicht emittierende Vorrichtung (10) nach Anspruch 1, wobei eine oberste Schicht (31a) der ersten reflektierenden Schicht (21) eine unterste Schicht der aktiven Schicht (19) ist.

6. Ultraviolettlicht emittierende Vorrichtung (10) nach Anspruch 1, wobei eine oberste Schicht (31a) der ersten reflektierenden Schicht (21) eine Sperrschicht der aktiven Schicht (19) ist.

7. Ultraviolettlicht emittierende Vorrichtung (10) nach Anspruch 1, wobei die aktive Schicht (19) einen Brechungsindex aufweist, der höher als der einer obersten Schicht der ersten reflektierenden Schicht (21) ist.

8. Ultraviolettlicht emittierende Vorrichtung (10) nach Anspruch 1, wobei die dritte leitfähige Halbleiterschicht (59) einen Brechungsindex aufweist, der höher als der einer untersten Schicht (31a) der ersten reflektierenden Schicht (21) ist.

9. Ultraviolettlicht emittierende Vorrichtung (10) nach Anspruch 1, wobei die erste reflektierende Schicht (21) ein Material zum Reflektieren eines Ultraviolettlichts mit einer Wellenlänge von 270 nm bis 290 nm umfasst.

10. Ultraviolettlicht emittierende Vorrichtung (10) nach Anspruch 1, wobei die erste reflektierende Schicht (21) einen Dotanten umfasst, der der gleiche Dotant wie der der ersten leitfähigen Halbleiterschicht (15) ist.

11. Ultraviolettlicht emittierende Vorrichtung (10) nach Anspruch 1, wobei die erste reflektierende Schicht (21) einen Dotanten umfasst, der der gleiche Dotant wie der der dritten leitfähigen Halbleiterschicht (59) ist.

12. Ultraviolettlicht emittierende Vorrichtung (10) nach Anspruch 1, wobei die erste reflektierende Schicht (21) ein Halbleitermaterial umfasst, das das gleiche Halbleitermaterial wie das der dritten leitfähigen Halbleiterschicht (59) ist.

13. Ultraviolettlicht emittierende Vorrichtung (10) nach Anspruch 2, wobei die erste reflektierende Schicht (21) ein Halbleitermaterial umfasst, das sich von dem der dritten leitfähigen Halbleiterschicht (59) unterscheidet.

14. Ultraviolettlicht emittierende Vorrichtung (10) nach Anspruch 2, wobei eine Schicht von der ersten reflektierenden Schicht (21), der vierten leitfähigen Halbleiterschicht (25) und der dritten leitfähigen Halbleiterschicht (59) ein Halbleitermaterial aufweist, das sich von dem der restlichen Schichten aus der ersten reflektierenden Schicht, der vierten leitfähigen Halbleiterschicht und der dritten leitfähigen Halbleiterschicht unterscheidet.

15. Ultraviolettlicht emittierende Vorrichtung (10) nach Anspruch 2, weiterhin umfassend:
eine erste Elektrode (41) unter der ersten leitfähigen Halbleiterschicht (15); und
eine zweite Elektrode (45) unter einer Schicht von der dritten leitfähigen Halbleiterschicht (59) und der vierten leitfähigen Halbleiterschicht (25),
wobei die erste reflektierende Schicht (21) mit mindestens einem Teil der ersten Elektrode (41) in horizontaler Richtung überlappt.

## Revendications

1. Dispositif luminescent ultraviolet (10), comprenant :
une première couche conductrice de semi-conducteur (15) incluant un dopant de type n;
une couche active (19) sous la première couche conductrice de semi-conducteur (15) ;
une deuxième couche conductrice de semi-conducteur (21) pour former une première couche réfléchissante sous la couche active (19) ; et
une troisième couche conductrice de semi-conducteur (59) incluant un dopant de type p sous la deuxième couche conductrice de semi-conducteur (21),
dans lequel la deuxième couche conductrice de semi-conducteur (21) comprend une pluralité de couches de semi-conducteur composé (31a, 31b, 33a, 33b, 35a) comprenant au moins deux matériaux semi-conducteurs, les teneurs des au moins deux matériaux semi-conducteurs étant différents l'une de l'autre,
dans lequel la première couche réfléchissante (21) comprend une pluralité de motifs (51) espacés les uns des autres, et
dans lequel la troisième couche conductrice de semi-conducteur (59) est directement en contact avec la couche active (19) entre les motifs (51).

2. Dispositif luminescent ultraviolet (10) selon la revendication 1, comprenant en outre :
une quatrième couche conductrice de semi-conducteur (25) sous la troisième couche de semi-conducteur conducteur (59).

3. Dispositif luminescent ultraviolet (10) selon la revendication 2, comprenant en outre :
une seconde couche réfléchissante (47) entre la quatrième couche conductrice de semi-conducteur (25) et la troisième couche conductrice de semi-conducteur (59).

4. Dispositif luminescent ultraviolet (10) selon la revendication 1, dans lequel une couche la plus basse et une couche la plus haute de la première couche réfléchissante (21) comprend au moins deux couches de semi-conducteur (31a, 35a) possédant les mêmes teneurs.

5. Dispositif luminescent ultraviolet (10) selon la revendication 1, dans lequel une couche la plus haute (31a) de la première couche réfléchissante (21) est une couche la plus basse de la couche active (19).

6. Dispositif luminescent ultraviolet (10) selon la revendication 1, dans lequel une couche la plus haute (31a) de la première couche réfléchissante (21) est une couche barrière de la couche active (19).

7. Dispositif luminescent ultraviolet (10) selon la revendication 1, dans lequel la couche active (19) possède un indice de réfraction supérieur à celui d'une couche la plus haute de la première couche réfléchissante (21).

8. Dispositif luminescent ultraviolet selon la revendication 1, dans lequel la troisième couche conductrice de semi-conducteur (59) possède un indice de réfraction supérieur à celui d'une couche la plus basse (31a) de la première couche réfléchissante (21).

9. Dispositif luminescent ultraviolet (10) selon la revendication 1, dans lequel la première couche réfléchissante (21) inclut un matériau pour réfléchir une lumière ultraviolette possédant une longueur d'onde de 270 nm à 290 nm.

10. Dispositif luminescent ultraviolet (10) selon la revendication 1, dans lequel la première couche réfléchissante (21) inclut un dopant identique à celui de la première couche conductrice de semi-conducteur (15).

11. Dispositif luminescent ultraviolet (10) selon la revendication 1, dans lequel la première couche réfléchissante (21) inclut un dopant identique à celui de la troisième couche conductrice de semi-conducteur (59).

12. Dispositif luminescent ultraviolet (10) selon la revendication 1, dans lequel la première couche réfléchissante (21) inclut un matériau semi-conducteur identique à celui de la troisième couche conductrice de semi-conducteur (59).

13. Dispositif luminescent ultraviolet (10) selon la revendication 2, dans lequel la première couche réfléchissante (21) inclut un matériau semi-conducteur différent de celui de la troisième couche conductrice de semi-conducteur (59).

14. Dispositif luminescent ultraviolet (10) selon la revendication 2, dans lequel une couche parmi la première couche réfléchissante (21), la quatrième couche conductrice de semi-conducteur (25) et la troisième couche conductrice de semi-conducteur (59) possède un matériau semi-conducteur différent de celui des autres couches parmi la première couche réfléchissante, la quatrième couche conductrice de semi-conducteur et la troisième couche conductrice de semi-conducteur.

15. Dispositif luminescent ultraviolet (10) selon la revendication 2, comprenant en outre :
une première électrode (41) sous la première couche conductrice de semi-conducteur (15) ; et
une seconde électrode (45) sous une couche parmi la troisième couche conductrice de semi-conducteur (59) et la quatrième couche conductrice de semi-conducteur (25),
dans lequel la première couche réfléchissante (21) chevauche au moins une portion de la première électrode (41) dans une direction horizontale.
